# EUROPÄISCHE PATENTSCHRIFT

(11) **EP 1 495 154 B1**
(45) Veröffentlichungstag und Bekanntmachung des Hinweises auf die Patenterteilung: **30.04.2008**
(21) Anmeldenummer: 03737956.7
(22) Anmeldetag: 15.04.2003
(51) Int. Cl.: C23C 14/10

(54) **VERFAHREN ZUR GEHÄUSEBILDUNG BEI ELEKTRONISCHEN BAUTEILEN SO WIE SO HERMETISCH VERKAPSELTE ELEKTRONISCHE BAUTEILE**
METHOD FOR FORMING HOUSINGS FOR ELECTRONIC COMPONENTS AND ELECTRONIC COMPONENTS THAT ARE HERMETICALLY ENCAPSULATED THEREBY
PROCEDE DE FORMATION DE BOITIERS DANS LE CADRE DE COMPOSANTS ELECTRONIQUES ET COMPOSANTS ELECTRONIQUES ENCAPSULES HERMETIQUEMENT

(30) Priorität: 15.04.2002 DE 20205830 U; 23.05.2002 DE 10222958; 23.05.2002 DE 10222964; 23.05.2002 DE 10222609; 13.11.2002 DE 10252787; 16.01.2003 DE 10301559
(43) Veröffentlichungstag der Anmeldung: 12.01.2005
(73) Patentinhaber: Schott AG, 55122 Mainz (DE)
(72) Erfinder: LEIB, Jürgen, 85354 Freising (DE); MUND, Dietrich, 84101 Obersüssbach (DE)
(74) Vertreter: Herden, Andreas F.
(86) Internationale Anmeldenummer: PCT/EP2003/003882
(87) Internationale Veröffentlichungsnummer: WO 2003/087424

(56) Entgegenhaltungen:
- CH-A- 387 175
- US-A- 4 374 391
- WOO-BEOM CHOI ET AL: "Anodic bonding technique under low temperature and low voltage using evaporated glass" 9TH INTERNATIONAL VACUUM MICROELECTRONICS CONFERENCE, ST. PETERSBURG, RUSSIA, 7-12 JULY 1996, Bd. 15, Nr. 2, Seiten 477-481, XP002251628 Journal of Vacuum Science & Technology B (Microelectronics and Nanometer Structures), March-April 1997, AIP for American Vacuum Soc, USA ISSN: 0734-211X

## Beschreibung

### Beschreibung

Die Erfindung bezieht sich auf ein Verfahren zur Gehäusebildung bei elektronischen Bauteilen sowie auf so hermetisch verkapselte elektronische Bauteile, insbesondere Sensoren, integrierte Schaltungen und optoelektronische Bauelemente.

Zur Kapselung von integrierten Schaltungen und optoelektronischen Bauelementen ist es bekannt, ein dünnes Glasplättchen mittels einer organischen Klebeschicht auf das Bauteil zu kleben und so die empfindlichen Halbleiterstrukturen abzudecken und zu schützen. Diese Bauweise hat den Nachteil, dass mit der Zeit Wasser in die organische Klebeschicht eindiffundieren kann, welches dann bis zu den Halbleiterstrukturen gelangen kann und diese beeinträchtigt. Die Klebeschichten können ferner durch UV-Bestrahlung altern, was vor allem für elektrooptische Bauteile schädlich ist.

Anstelle organischer Klebemittel ist auch schon niedrig schmelzendes Glaslot als Zwischenschicht verwendet worden, welches aufgesprüht, aufgesputtert bzw. mittels Siebdruck-und Dispensertechnologie aufgetragen worden ist. Die Prozesstemperatur beim Aufschmelzen der Glaslotschicht ist jedoch höher als T=300°C, so dass temperaturempfindliche Halbleiterstrukturen nicht verkapselt werden können.

Der Erfindung liegt deshalb die Aufgabe zugrunde, ein Verfahren zur Kapselung von elektronischen Bauteilen anzugeben, mit dem eine weitgehend wasserdiffusionsfeste Kapselung bei mäßigen Temperaturen unterhalb von 300°C, vorzugsweise unterhalb 150°C erzielt werden kann.

Die gestellte Aufgabe wird aufgrund der Maßnahmen des Anspruches 1 gelöst und durch die weiteren Maßnahmen der abhängigen Ansprüche ausgestaltet und weiterentwickelt. Anspruch 23 betrifft ein erfindungsgemäß herstellbares elektronisches Bauteil, wobei vorteilhafte Weiterbildungen und Ausgestaltungen in den von Anspruch 23 abhängigen Ansprüchen angegeben sind.

Ein Vorteil des Beschichtens mit einem Aufdampfglas ist das Aufbringen der isolierenden Glasschicht bei Raumtemperatur bis etwa 150°C, so dass keinerlei Schädigung oder Oxidation der Substratoberfläche, auch bei Metallsubstraten zu erwarten ist. Diesbezüglich wird auch auf die Anmeldungen
DE 202 05 830.1, eingereicht am 15.04.2002,
DE 102 22 964.3, eingereicht am 23.05.2002;
DE 102 22 609.1, eingereicht am 23.05.2002;
DE 102 22 958.9, eingereicht am 23.05.2002;
DE 102 52 787.3, eingereicht am 13.11.2002;
DE 103 01 559.0, eingereicht am 16.01.2003;
desselben Anmelders verwiesen.

Hinsichtlich der Barriereeigenschaften von Aufdampfglasschichten haben Messungen gezeigt, daß bei Schichtdicken der Aufdampfglasschicht im Bereich von 8 µm bis 18 µm Helium-Leckraten von kleiner als 10⁻⁷ mbar 1 s⁻¹ oder kleiner als 10⁻⁸ mbar 1 s⁻¹ sicher erreicht werden. Die Messungen haben bei Schichten mit einer Schichtdicke von 8 µm und 18 µm sogar Helium-Leckraten zwischen 0 bis 2x10⁻⁹ mbar 1 s⁻¹ ergeben, wobei diese oberen Grenzwerte bereits im wesentlichen durch die Meßungenauigkeit der durchgeführten Versuche beeinflußt sind.

Das erfindungsgemäße Verfahren der Kapselung mit Aufdampfglas kann bereits angewendet werden, wenn das elektronische Bauteil noch in der Herstellung begriffen ist.

Die Verstärkung des Substrats des elektronischen Bauteils durch die aufgedampfte Glasschicht wird ausgenutzt, das Substrat zu stabilisieren, während auf das Substrat von der nicht eingekapselten Seite her eingewirkt wird. Das ansonsten fertig hergestellte elektronische Bauteil kann auch von der Anschlußseite her - unter Freilassung der Anschlüsse - eingekapselt werden. Dazu kann beispielsweise das Substrat auf einer Seite, die einer ersten Seite mit den Halbleiterstrukturen gegenüberliegt, mit einer Passivierungsschicht versehen werden. Dazu ist beispielsweise eine Kunststoffschicht geeignet. Die Passivierungsschicht kann auch eine Glasschicht umfassen, die bevorzugt auf diese Seite aufgedampft wird.

Insbesondere ist das Verfahren zur Verpackung von Bauelementen im Waferverbund ("Wafer-Level-Packaging") geeignet, wobei in diesem Fall das Substrat einen Wafer mit den Substraten der Bauelementen umfaßt, die nach der Verpackung vom Wafer abgetrennt werden können.

Je nach den Anforderungen kann die Dicke der aufgedampften Glasschicht 0,01 bis 1000 µm betragen. Wenn es nur auf hermetischen Abschluss des zu schützenden Bauteils ankommt, liegt die bevorzugte Glasschichtdicke im Bereich zwischen 0,1 und 50 µm. Für stärkere Belastungen wird die Glassehichtdicke entsprechend dicker gewählt, wobei ein bevorzugter Bereich der Glasschichtdicke zwischen 50 und 200 µm liegt. Ein Aufbau von Mehrfachschichten auch in Kombination mit anderen Materialien ist ebenso möglich. Es ist auch möglich, die Glasschicht mit einer aufgebrachten Kunststoffschicht zu kombinieren, um zu einer strukturellen Verstärkung des elektronischen Bauteils zu gelangen.

Es gibt verschiedene Möglichkeiten, Glas aufzudampfen. Bevorzugt wird die Erzeugung des Glasdampfes mittels Elektronenstrahl aus einem Glasvorrats-Target vorgenommen. Es können Aufdampfraten von mehr als 4µm/min. erzeugt werden und das hergestellte Glas scheidet sich mit festem Verbund auf der Oberfläche des Substrats ab, ohne dass es eines erhöhten H₂O-Gehalt zwecks Bindungswirkung bedarf wie bei niedrig schmelzendem Glaslot. Als Aufdampfglas wird ein Borosilikatglas mit Anteilen von Aluminiumoxid und Alkalioxid bevorzugt, wie es das Aufdampfglas vom Typ 8329 der Firma Schott Glas darstellt. Dieses Glas hat außerdem einen Wärmeausdehnungskoeffizienten, der dem des Substrats von üblichen Halbleiterstrukturen nahekommt, bzw. durch entsprechende Abwandlung in den Komponenten an den Wärmeausdehnungskoeffizienten des Substrats angepasst werden kann. Es kann Aufdampfglas anderer Zusammensetzung verwendet werden, insbesondere in mehreren Schichten übereinander, wobei die Gläser der Schichten unterschiedliche Eigenschaften hinsichtlich Brechungsindex, Dichte, Härte usw. besitzen können.

Vorteilhaft kann das Bedampfen des Substrats mit einer Glasschicht auch das Plasma-Ionen-unterstützte Aufdampfen (PIAD) umfassen. Dabei wird zusätzlich ein Ionenstrahl auf das zu beschichtende Substrat gerichtet. Der Ionenstrahl kann mittels einer Plasmaquelle, beispielsweise durch Ionisation eines geeigneten Gases erzeugt werden. Durch das Plasma erfolgt eine zusätzliche Verdichtung der Schicht sowie die Ablösung lose haftender Partikel auf der Substratoberfläche Dies führt zu besonders dichten und defektarmen abgeschiedenen Schichten.

Weiterhin kann durch geeignete Materialkombination das Aufbringen einer Mischschicht aus anorganischen und organischen Bestandteilen realisiert werden. Diese Mischschicht ist durch eine Verringerung der Sprödigkeit gekennzeichnet.

Wenn die Glasschicht auf einer ersten Seite des Substrats des elektronischen Bauteils aufgebracht wird, während dieses elektronische Bauteil noch nicht fertig hergestellt ist, kann es zur Handhabung bei dieser Fertigherstellung zweckmäßig sein, eine das Bauteil verstärkende Kunststoffschicht über der Glasschicht anzubringen. In diesem Fall wird die Glasschicht in einer Dicke erzeugt, die für die Abkapselung bzw. den hermetischen Abschluss gegenüber eindringenden diffundierenden Stoffen genügt, während die Kunststoffschicht in einer Dicke erzeugt wird, wie sie für die Stabilisierung bei der Weiterverarbeitung des Bauteils benötigt wird.

In einem solchen Fall kann Material von der zweiten nicht gekapselten Substratseite abgetragen werden, so dass Anschlüsse an das Bauteil hergestellt werden können, die von der Unterseite in das Bauteil hineinreichen und somit durch das Bauteil selbst geschützt sind, wenn dieses endgültig von seinem Einsatzort eingebaut wird. Dies ist vor allem im Falle von Sensoren bedeutsam.

Die Erfindung wird anhand der Zeichnung beschrieben. Dabei zeigt:
- Fig. 1: einen Abschnitt eines Wafers mit einer aufgedampften Glasschicht,
- Fig. 2: einen Waferabschnitt mit Glas und Kunststoffschicht,
- Fig. 3: die Herstellung von Anschlüssen an den Wafer,
- Fig. 4: die zusätzliche Kunststoff-Passivierung der Waferunterseite,
- Fig. 5: die Beschichtung der Waferunterseite mit Aufdampfglas,
- Fig. 6: das Anbringen eines Ball Grid Arrays an den Wafer gemäß Fig. 5,
- Fig. 7: eine weitere Anbringungsart des Ball Grid Arrays,
- Fig. 8: die Kapselung der Unterseite eines Wafers,
- Fig. 9: das Anbringen der Ball Grid Arrays am Wafer der Fig. 8,
- Fig. 10: ein Schema einer Verdampfungsanordnung,
- Fig. 11: Ergebnisse einer TOF-SIMS-Messung, und
- Fig. 12: eine elektronenmikroskopische Querschliff-Aufnahme.

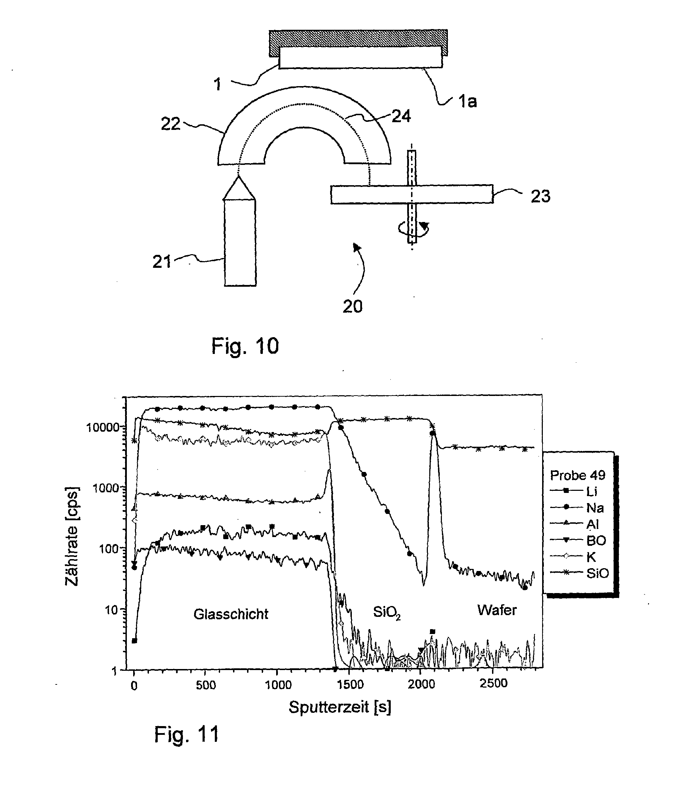

Fig. 10 zeigt die Anordnung eines Substrats 1 zu einer Aufdampfglasquelle 20. Diese umfaßt einen Elektronenstrahlerzeuger 21, eine Strahlumlenkeinrichtung 22 und ein Glastarget 23, das von einem Elektronenstrahl 24 getroffen wird. An der Auftreffstelle des Elektronenstrahls verdampft das Glas und schlägt sich an der ersten Seite 1a des Substrats 1 nieder. Um das Glas des Targets 23 möglichst gleichmäßig verdampfen zu lassen, wird das Target gedreht und der Strahl 24 gewobbelt. Zusätzlich kann die Anordnung noch eine Plasmaquelle zur Erzeugung eine Ionenstrahls umfassen, welcher im Betrieb in Richtung auf die zu beschichtende Seite 1a gerichtet ist, um das Substrat mittels Plasma-Ionenunterstütztem Aufdampfens (PIAD) mit einer Glasschicht zu beschichten.

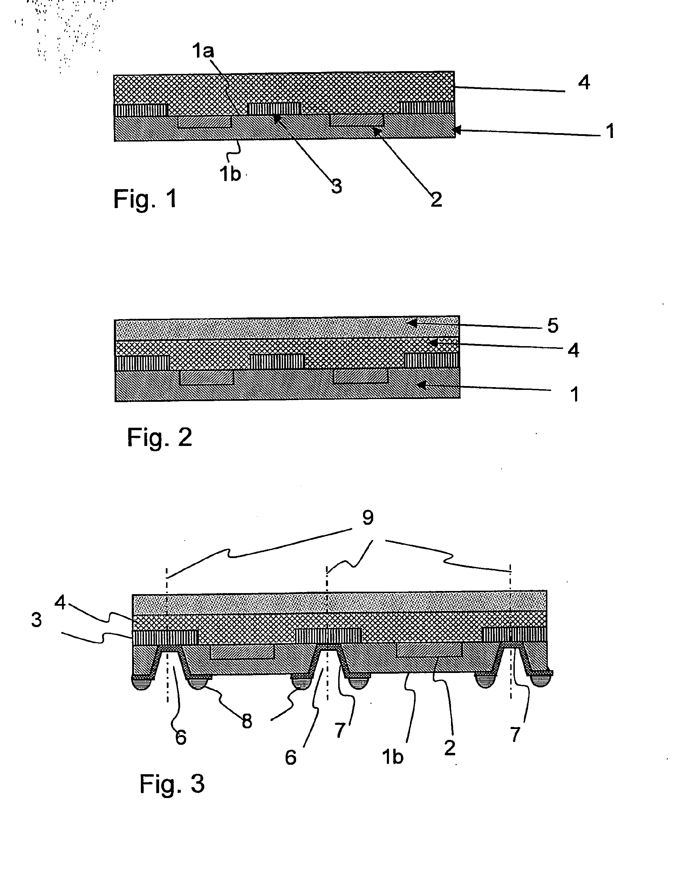

Wegen näherer Einzelheiten des möglichen Substrats 1 wird Bezug auf Fig. 1 genommen. Ein Siliziumwafer als das Substrat 1 weist Bereiche 2 mit Halbleiterstrukturen sowie Bereiche 3 mit Anschlußstrukturen auf, beispielsweise aus Aluminium. Die Anschlußstrukturen können beispielsweise Bond-Pads oder andere Anschlußflächen umfassen. Der Siliziumwafer stellt ein Substrat mit einer Oberflächenrauhigkeit < 5µm dar. Die Oberseite 1a des Substrats liegt der Unterseite 1b gegenüber. Auf die Oberseite 1a ist eine Glasschicht 4 niedergeschlagen worden, die vorzugsweise aus dem Aufdampfglas des Typs 8329 der Firma Schott gewonnen wurde. Dieser Glastyp kann durch Einwirkung des Elektronenstrahls 24 weitgehend verdampft werden, wobei man in evakuierter Umgebung mit 10⁻⁴ mbar Restdruck und einer BIAS Temperatur während der Verdampfung von 100°C arbeitet. Unter diesen Bedingungen wird eine dichte geschlossene Glasschicht 4 erzeugt, die weitgehend gegenüber Gasen und Flüssigkeiten, auch Wasser, dicht ist, jedoch Licht durchlässt, was im Falle von elektrooptischen Bauteilen wichtig ist.

Die Glasschicht 4 kann auch mehrere Schichten, beispielsweise aus Gläsern mit unterschiedlicher Zusammensetzung aufweisen. Auch kann die Glasschicht eine Mischschicht aus anorganischen und organischen Bestandteilen umfassen, um beispielsweise eine erhöhte Schichtflexibilität zu erreichen.

Die Unterseite 1b des Wafers steht für weitere Bearbeitungsschritte zur Verfügung, welche das Nass-, Trocken- und Plasmaätzen bzw. -reinigen umfassen.

Wird, wie in Fig. 1 und den weiteren Fig. 2 bis 9 ein Wafer als Substrat verwendet, kann das erfindungsgemäße Verfahren zweckmäßig zur Verpackung von Bauelementen im Waferverbund eingesetzt werden. Das Verfahren läßt sich in analoger Weise jedoch auf bereits vereinzelte Chips mit Halbleiterstrukturen und Anschlußstrukturen anwenden.

Fig. 2 zeigt eine Deckschicht des Substrats 1, die aus einer Glasschicht 4 und einer Kunststoffschicht 5 besteht. Die Glasschicht 4 hat eine Dicke im Bereich von 1 bis 50 µm, was für die Abkapselung bzw. den hermetischen Abschluss genügt, während die Kunststoffschicht 5 dicker ist, um dem Wafer als Werkstück größere Stabilität für nachfolgende Bearbeitungsschritte zu verleihen.

In Fig. 3 ist die weitere Bearbeitung eines Wafers angedeutet. Der Wafer wird an der Unterseite gedünnt, so daß die erfindungsgemäß herstellbaren Bauelemente ein ausgedünntes Substrat aufweisen, und es werden Ätzgruben 6 erzeugt, die bis zu den Anschlussstrukturen 3 reichen, welche als Ätzstop wirken. Die Waferunterseite 1b wird mit einer Kunststofflithographie versehen, wobei die Bereiche der Anschlussstrukturen 3 offen bleiben. Es werden nunmehr Leitungskontakte 7 auf der Unterseite erzeugt, was beispielsweise durch Besprühen oder Besputtern geschieht, wodurch leitfähige Schichten 7 im Bereich der Ätzgruben 6 erzeugt werden. Nunmehr wird der bei der Lithographie verwendete Kunststoff von der Waferunterseite 1b entfernt. Alsdann wird ein Ball Grid Array 8 an den leitfähigen Schichten 7 angebracht und der Wafer wird entlang von Ebenen 9 aufgetrennt. Es entstehen eine Mehrzahl von elektronischen Bauteilen, deren Halbleiterstrukturen 2 sicher zwischen der Deckschicht 4 und dem Substrat 1 eingebettet und hermetisch verschlossen ist.

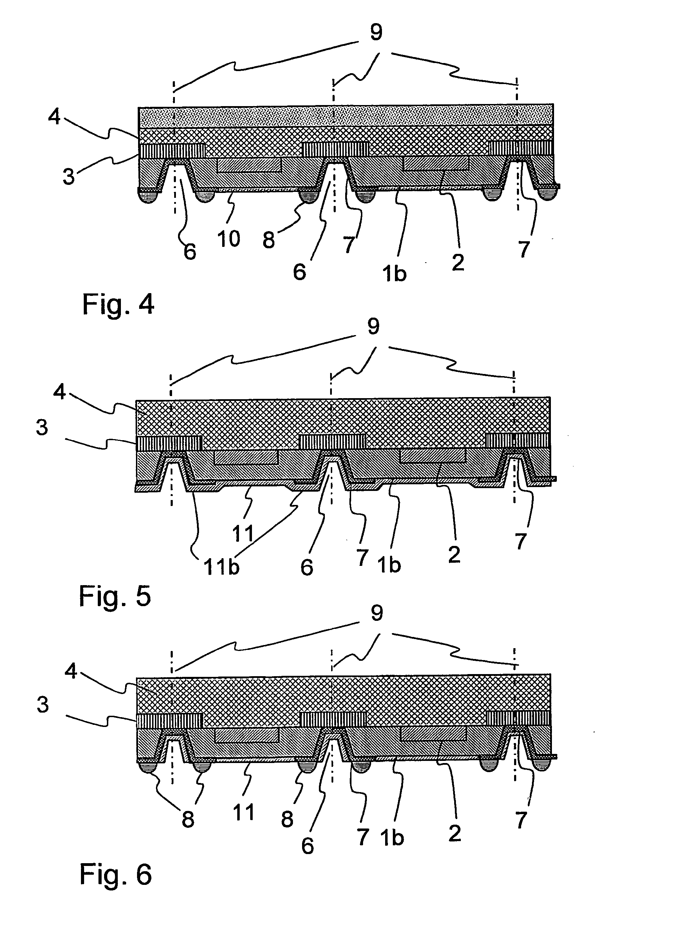

Fig. 4 zeigt eine Abwandlung der Ausführungsform der Fig. 3. Es werden die gleichen Verfahrensschritte wie zuvor ausgeführt, jedoch wird der Kunststoff an der Waferunterseite 1b nicht entfernt und bedeckt die Unterseite als Passivierungs- und Schutzschicht 10.

Fig. 5 zeigt eine Ausführungsform, bei der anstelle der Kunststoffschicht 10 eine aufgedampfte Glasschicht 11 auf der Unterseite 1b des Substrats aufgebracht werden soll. Wie bei der Ausführungsform der Fig. 3 wird der zur Lithographie verwendete Kunststoff an der Waferunterseite 1b entfernt und die gesamte Waferunterseite 1b wird mit dem Glas bedampft, so dass eine 1 bis 50µm starke Glasschicht 11 entsteht.

Die in Fig. 5 gezeigte Glasschicht 11 dient, ebenso wie die in Fig. 4 dargestellte Kunststoffschicht 10 dabei als Schutz-oder Passivierungsschicht.

Wie bei 11b dargestellt, bedeckt diese Glasschicht auch die nach außen ragenden Teile der Leitungskontakte 7. Zum Anbringen eines Ball Grid Arrays 8 werden diese Bereiche 11b durch Wegschleifen und / oder Wegätzen freigelegt. Danach werden die Ball Grid Arrays angebracht, wie Fig. 6 zeigt, und es erfolgt eine Auftrennung des Wafers zur Bildung einzelner Bauteile, wie bei 9 angedeutet. Die empfindlichen Halbleiterstrukturen 2 sind nach oben und nach unten jeweils durch eine Glasschicht 4 bzw. 11 geschützt.

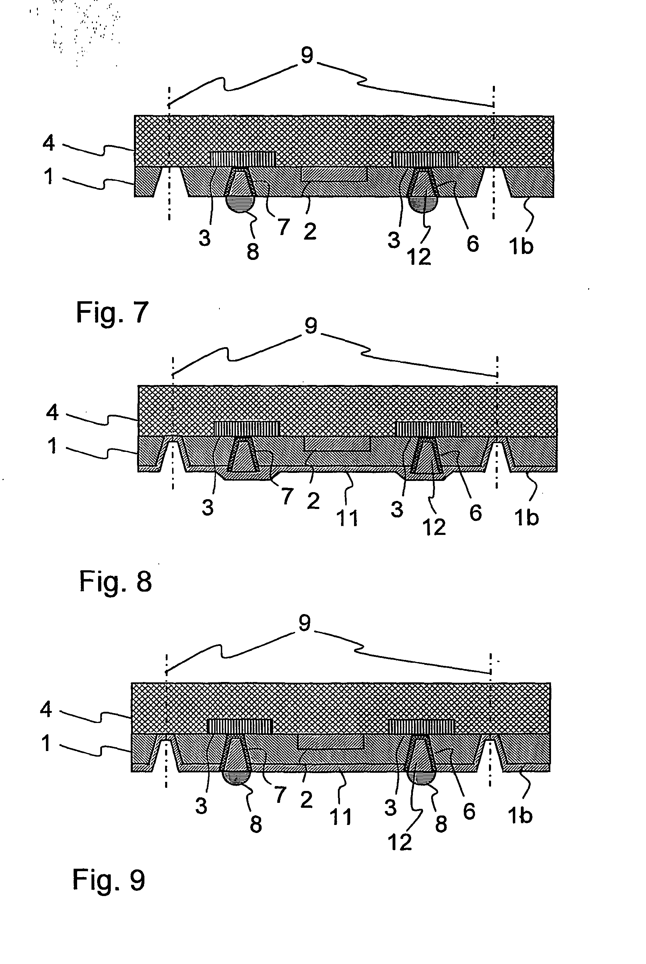

Bei einer weiteren Ausführungsform der Erfindung wird der Wafer an Trennebenen 9, die nicht durch die Anschlussstrukturen verlaufen, aufgetrennt. Dies hat den Vorteil, dass auch ein seitlicher Passivierungsschutz für die Bauteile gewährleistet werden kann. Fig. 7 zeigt ein Beispiel der Auftrennung, bei welchem nur Material der Deckschicht 4 und des Substrats 1 betroffen ist. Es wird zunächst wie bei den zuvor beschriebenen Ausführungsbeispielen vorgegangen, d.h. der Wafer wird von der Unterseite gedünnt und es werden Ätzgruben 6 erzeugt, die bis zur Unterseite der Anschlussstrukturen 3 reichen. Die Waferunterseite 1b wird lithographiert, wobei die Bereiche der Anschlussstrukturen offen bleiben. Die Leitungskontakte 7 werden im Bereich der Ätzgruben 6 erzeugt, wobei die Ätzgruben außerdem mit leitfähigem Material 12 gefüllt werden. Hier kommt die galvanische Verstärkung durch Ni(P) in Betracht. Die gemäß dieser Ausführungsform der Erfindung herstellbaren Bauelemente weisen dementsprechend Durchkontaktierungen durch das Substrat auf.

Nachdem der Kunststoff an der Waferunterseite wenigstens im Bereich der Kontakte 7 entfernt worden ist, werden die Ball Grid Arrays 8 angebracht. Danach erfolgt die Auftrennung des Wafers entlang von Ebenen 9. Man erhält elektronische Bauteile mit hermetische eingeschlossenen Halbleiterstrukturen 2, wobei je nach Vorgehensweise eine analoge Kunststoffschicht 10 vorhanden ist oder fehlt.

Fig. 8 und 9 zeigen ein Ausführungsbeispiel mit der Erzeugung einer unterseitigen Glasschicht 11. Es wird analog zur Ausführungsform der Fig. 5 in Verbindung mit Fig. 7 vorgegangen, d.h. es werden gefüllte Bereiche unter den Anschlussstrukturen erzeugt und die gesamte Unterseite 1b des Wafers wird mit der Glasschicht 11 beschichtet, die anschließend im Bereich der gefüllten Ätzgruben 6 entfernt wird, um darauf die Ball Grid Arrays anzubringen, wie in Fig. 9 dargestellt. Nach Auftrennung entlang der Ebenen 9 werden Bauteile mit gekapselten Halbleiterstrukturen 2 erzielt.

Das Glassystem der Schicht 4 bzw. 11 sollte wenigstens ein binäres System darstellen. Bevorzugt werden Mehrkomponentensysteme.

Als besonders geeignet hat sich Aufdampfglas erwiesen, welches folgende Zusammensetzung in Gewichtsprozent aufweist:

| Komponenten | Gew % |
|---|---|
| SiO₂ | 75 - 85 |
| B₂O₃ | 10 - 15 |
| Na₂O | 1 -5 |
| Li₂O | 0, 1 - 1 |
| K₂O | 0,1 - 1 |
| Al₂O₃ | 1 - 5 |

Ein bevorzugtes Aufdampfglas dieses Typs ist das Glas 8329 der Firma Schott mit der folgenden Zusammensetzung:

| | |
|---|---|
| SiO₂ | 84,1 % |
| B₂O₃ | 11,0 % |

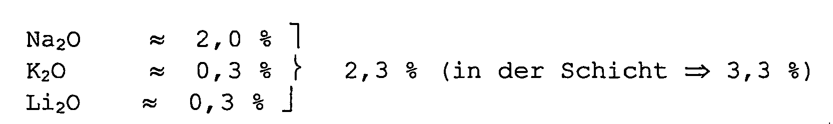

Al₂O₃ ≈ 2,6 % (in der Schicht < 0,5 %)
Die Werte in Klammern sind die Gewichtsanteile der jeweiligen Komponente in der aufgedampften Schicht.
Der elektrische Widerstand beträgt ungefähr 10¹⁰ Ω/cm (bei 100°C),
der Brechungsindex etwa 1,470,
die Dielektrizitätskonstante ε etwa 4,7 (bei 25°C, 1 MHz)
tgδ etwa 45 X 10⁻⁴ (bei 25°C, 1 MHz).

Ein weitere Gruppe geeigneter Aufdampfgläser weist die folgende Zusammensetzung in Gewichtsprozent auf:

| Komponenten: | Gew% |
|---|---|
| SiO₂ | 65 - 75 |
| B₂O₃ | 20 - 30 |
| Na₂O | 0,1 - 1 |
| Li₂O | 0,1 - 1 |
| K₂O | 0,5 - 5 |
| Al₂O₃ | 0,5 - 5 |

Ein bevorzugtes Aufdampfglas aus dieser Gruppe ist das Glas G018-189 der Firma Schott mit der folgenden Zusammensetzung:

| Komponenten: | Gew% |
|---|---|
| SiO₂ | 71 |
| B₂O₃ | 26 |
| Na₂O | 0,5 |
| Li₂O | 0, 5 |
| K₂O | 1, 0 |
| Al₂O₃ | 1,0 |

Die bevorzugt verwendeten Gläser 8329 und G018-189 besitzen insbesondere die in der nachstehenden Tabelle aufgeführten Eigenschaften:

| Eigenschaften | 8329 | G018-189 |
|---|---|---|
| α₂₀₋₃₀₀ [10⁻⁶K⁻¹] | 2,75 | 3,2 |
| Dichte (g/cm³) | 2,201 | 2,12 |
| Transformationspunkt [°C] | 562 | 742 |
| Brechungsindex nd | 1,469 | 1,465 |
| Wasserbeständigkeitklasse nach ISO 719 | 1 | 2 |
| Säurebeständigkeitsklasse nach DIN 12 116 | 1 | 2 |
| Laugenbeständigkeitsklasse nach DIN 52322 | 2 | 3 |
| Dielektrizitätskonstante ε (25 °C) | 4,7 (1MHz) | 3,9 (40GHz) |
| tanδ (25 °C) | 45*10⁻⁴ (1MHz) | 26*10⁻⁴ (40GHz) |

Zur Erzielung besonderer Eigenschaften der Bauteile kann es zweckmäßig sein, Gläser unterschiedlicher Glaszusammensetzungen für die Glasschichten der Oberseite und der Unterseite zu verwenden. Es ist auch möglich, mehrere Gläser mit unterschiedlichen Eigenschaften, z.B. hinsichtlich Brechungsindex, Dichte, E-Modul, Knoophärte, Dielektrizitätskonstante, tanδ nacheinander auf das Substrat aufzudampfen.

Anstelle der Elektronenstrahlverdampfung können auch andere Mittel zur Überführung von Materialien, die sich als Glas niederschlagen, angewendet werden. Das Verdampfungsmaterial kann sich beispielsweise in einem Tiegel befinden, der durch eine Elektronenstoßheizung aufgeheizt wird. Eine solche Elektronenstoßheizung beruht auf der Emission von Glühelektronen, die auf den Tiegel hin beschleunigt werden, um mit vorbestimmter kinetischer Energie auf das zu verdampfende Material aufzutreffen. Auch mit diesen Verfahren lassen sich Glasschichten erzeugen, ohne das Substrat, auf dem sich das Glas niederschlägt, allzu stark thermisch zu belasten.

Im Folgenden sind Ergebnisse verschiedener Untersuchungen von aufgedampften Glasschichten aus dem Glas 8329 dargestellt.

Bezugnehmend auf Fig. 11 sind die Ergebnisse einer TOF-SIMS-Messung gezeigt, wobei die Zählrate als Funktion der Sputterzeit aufgetragen ist. Die Messung charakterisiert den Verlauf der Elementkonzentrationen in Richtung senkrecht zur Substratoberfläche. Es wurde eine Dickenkonstanz für den Glasrahmen von < 1% der Schichtdicke ermittelt.

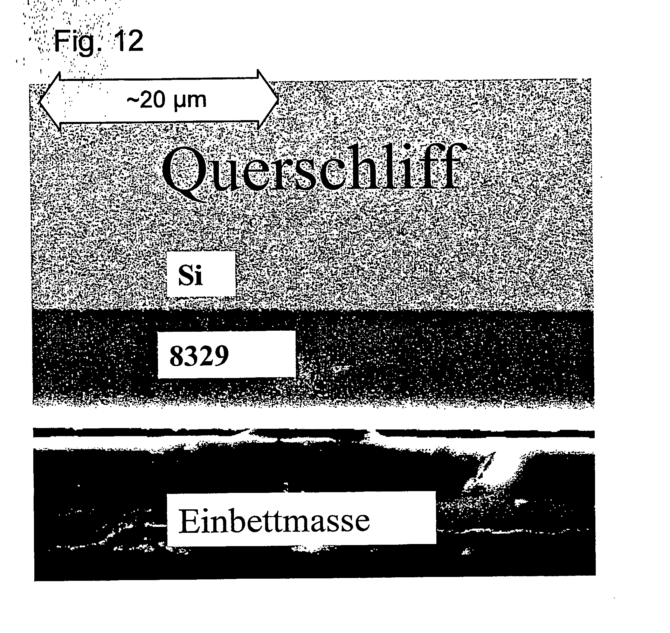

Fig. 12 zeigt eine elektronenmikroskopische Querschliff-Aufnahme eines mit dem Aufdampfglas 8329 beschichteten Siliziumsubstrats dargestellt. Das Aufdampfglas und die Oberfläche des Siliziumsubstrats zeigen einen festen Verbund, der sich auch durch den Querschliff bei der Präparation der Probe nicht löst.

Ferner wurden Beständigkeitsmessungen einer Aufdampfglasschicht aus aufgedampftem Glas 8329 nach flIN/ISO durchgeführt. Die Ergebnisse sind in Tabelle 1 wiedergegeben.

**Tabelle 1:**

| Probenbezeichnung: | **8329** | | |
|---|---|---|---|
| **Wasser DIN ISO 719** Klasse | Verbrauch HCI [ml/g] | Äquivalent Na₂O [µg/g] | Bemerkungen |
| **HGB 1** | **0,011** | **3** | **keine** |

| **Säure DIN 12116** Klasse | Abtrag [mg/dm²] | Gesamt-Oberfläche [cm²] | Bemerkungen/ sichtbare Veränderungen |
|---|---|---|---|
| **1 W Als Werkstoff** | **0,4** | **2 x 40** | **unverändert** |

| **Lauge DIN ISO 695** Klasse | Abtrag [mg/dm²] | Gesamt-Oberfläche [cm²] | Bemerkungen/ sichtbare Veränderungen |
|---|---|---|---|
| **A 2 Als Werkstoff** | **122** | **2 x 14** | **unverändert** |

## Patentansprüche

1. Verfahren zur Gehäusebildung bei elektronischen Bauteilen, insbesondere Sensoren, integrierten Schaltungen und optoelektronischen Bauelementen; mit folgenden Schritten:
- Bereitstellen eines Substrats (1), welches einen oder mehrere Bereiche mit Halbleiterstrukturen (2) sowie mit Anschlussstrukturen (3) oder zur Bildung von Halbleiterstrukturen (2) und Anschlussstrukturen (3) aufweist, wobei wenigstens eine erste Substratseite (1a) zu verkagseln ist,
- Bereitstellen einer Aufdampfglasquelle (20),
- Anordnen der ersten Substratseite (1a) relativ zur Aufdampfglasquelle derart, dass die erste Substratseite (1a) bedampft werden kann;
- Bedampfen der ersten Substratsseite mit einer Glasschicht (4),
- Ausdünnen des Substrats (1) an der Unterseite (1b).
- Erzeugen von Ätzgruben (6),
- Erzeugen von Leitungskontakten (7) auf der Unterseite (1b).

2. Verfahren nach Anspruch 1, **dadurch gekennzeichnet, daß** der eine oder die mehreren Bereiche mit Halbleiterstrukturen (2) auf der ersten Seite (1a) des Substrats angeordnet sind.

3. Verfahren gemäß Anspruch 2, **dadurch gekennzeichnet, daß** das Substrat auf einer der ersten Seite (1a) gegenüberliegenden zweiten Seite (1b) mit einer Passivierungsschicht (10, 11) versehen wird.

4. verfahren gemäß einem der vorstehenden Ansprüche, wobei das Substrat einen Wafer umfaßt, **dadurch gekennzeichnet, daß** das Verfahren das Verpacken von Bauelementen im Waferverbund umfaßt.

5. Verfahren gemäß einem der vorstehenden Ansprüche, **dadurch gekennzeichnet, daß** das Substrat (1) auf zwei Seiten (1a 1b) mit einer Glasschicht (4,10,11) bedampft wird.

6. Verfahren gemäß einem der vorstehenden Ansprüche, **dadurch gekennzeichnet, daß** eine Aufdampfglasquelle (20) bereitgestellt wird, die wenigstens ein binäres Glassystem erzeugt.

7. Verfahren gemäß einem der vorstehenden Anprüche, **dadurch gekennzeichnet, daß** die Aufdampfglasquelle (20) solange betrieben wird, bis die Glasschicht (4) insbesondere auf der ersten Substratseite eine Dicke im Bereich von 0,01 bis 1000 µm aufweist.

8. Verfahren gemäß einem der vorstehenden Ansprüche, **dadurch gekennzeichnet, daß** beim Bereitstellen einer Aufdampfglasquelle (20), ein Reservoir mit organischen Bestandteilen bereitgestellt wird, die durch Anlegen eines Vakuums oder durch Erwärmung in den gasförmigen Zustand übergehen, so dass während der Bedampfung Mischschichten aus anorganischen und organischen Bestandteilen auf der Substratseite gebildet werden können.

9. Verfahren gemäß einem der vorstehenden Ansprüche, **dadurch gekennzeichnet, dass** die Glasschichtdicke im Bereich zwischen 0,1 bis 50 µm liegt.

10. Verfahren gemäß einem der vorstehenden Ansprüche, **dadurch gekennzeichnet, dass** die Glasschichtdicke im Bereich zwischen 50 bis 200 µm liegt.

11. Verfahren gemäß einem der vorstehenden Ansprüche, **dadurch gekennzeichnet, dass** das Aufdampfglas der Quelle (20) mittels Elektronenstrahl (24) aus einem Glastarget (23) erzeugt wird.

12. Verfahren gemäß einem der vorstehenden Ansprüche, **dadurch gekennzeichnet, dass** als Aufdampfglas ein Borosilikatglas mit Anteilen von Aluminiumoxid und Alkalioxiden verwendet wird.

13. Verfahren gemäß einem der vorstehenden Ansprüche, **dadurch gekennzeichnet, dass** das Aufdampfglas einen Wärmeausdehnungskoeffizienten nahezu gleich dem des Substrates ausweist.

14. Verfahren gemäß einem der vorstehenden Ansprüche, **dadurch gekennzeichnet, dass** die Glasschicht (4) in einer Dicke erzeugt wird, wie sie zum hermetischen Abschluss erforderlich ist, und dass eine Kunststoffschicht (5) über der Glasschicht (4) aufgetragen wird, um die weitere Verarbeitung des Substrates (1) zu erleichtern.

15. verfahren gemäß einem der vorstehenden Ansprüche, **dadurch gekennzeichnet, dass** mehrere Schichten Glas auf das Substrat (1) aufgedampft werden, wobei die Glasschichten aus unterschiedlichen Glaszusammensetzungen bestehen können.

16. Verfahren gemäß einem der vorstehenden Ansprüche, **dadurch gekennzeichnet, dass** die weitere Verarbeitung des Substrates (1) den Abtrag von Material an einer zweiten Substratseite (1b) umfasst, die der ersten Substratseite (1a) gegenüberliegt.

17. Verfahren gemäß einem der vorstehenden Ansprüche, **dadurch gekennzeichnet, dass** das Substrat (1) einen Wafer mit mehreren Halbleiterstrukturen (2) und Anschlußstrukturen (3) aufweist, wobei
die zweite, der ersten Substratseite (1a) gegenüberliegende Substratseite (1b) gedünnt wird,
an der zweiten Substratseite (1b) im Bereich der herzustellenden Anschlussstrukturen Gruben (6) geätzt werden,
die Bereiche zur Bildung der Halbleiterstrukturen (2) unter Verwendung von Kunststoffschichten lithographiert werden,
auf der zweiten Substratseite (1b) in den Bereichen mit Anschlußstrukturen (3) Leitungskontakte (7) hergestellt werden,
der Kunststoff von der zweiten Substratseite (1b) entfernt wird,
ein Ball Grid Array (8) an den Leitungskontakten (7) aufgebracht wird, und
der wafer zur Bildung mehrerer elektronischer Bauteile aufgetrennt wird, die jeweils erste, verkapselte Seiten (1a) aufweisen.

18. verfahren nach Anspruch 17, **dadurch gekennzeichnet, dass** die zweite Substratseite (1b) mit einem Kunststoffüberzug (10) unter Aussparung der Ball Grid Bereiche (8) versehen wird.

19. Verfahren nach Anspruch 17 oder 18,
**dadurch gekennzeichnet,**
**dass** nach Entfernung des Kunststoffes von der zweiten Substratseite (1b) die zweite Substratseite insgesamt mit einer Glasschicht (11) bedampft wird, und
**dass** die Leitungskontakte (7) durch örtliche Beseitigung der Glasschicht (11) freigelegt werden, wonach die Schritte des Aufbringens des Ball Grid Arrays (8) und des Auftrennens erfolgen, um beidseitig verkapselte elektronische Bauteile zu erhalten.

20. verfahren nach Anspruch 19, **dadurch gekennzeichnet, daß** die zweite Substratseite insgesamt mit einer Glasschicht (11) im Bereich von 1 bis 50 µm Dicke bedampft wird, und

21. Verfahren nach einem der Ansprüche 17 bis 20,
**dadurch gekennzeichnet, dass** die Ätzgruben (6); die bis zu den Anschlußstrukturen (3) führen, mit leitfähigem Material (12) gefüllt werden, wonach mit oder ohne Entfernung des Kunststoffes (10) an der zweiten Substratseite (1b) sowie mit oder ohne Glasschicht (11) auf der zweiten Substratseite (1b) unter Freilassung der Leitungskontakte (7) das Ball Grid Array (8) an den Leitungskontakten (7) bzw. an dem Füllmaterial aufgebracht wird.

22. Verfahren gemäß einem der vorstehenden Ansprüche, **dadurch gekennzeichnet, daß** das Bedampfen der ersten Substratsseite (1a) mit einer Glasschicht (4) das Plasma-Ionen-unterstützte Aufdampfens (PIAD) umfasst.

23. Elektronisches Bauteil, insbesondere als Sensor oder als
integrierte Schaltung oder als optoelektronisches Bauelement, herstellbar mit einem Verfahren gemäß einem der vorstehenden Ansprüche.

24. Elektronisches Bauteil nach Anspruch 23, welches auf einer ersten Seite (1a) einen oder mehrere Bereiche mit Halbleiterstrukturen (2), sowie Anschlussstrukturen (3) aufweist,
**dadurch gekennzeichnet, daß** das Substrat auf zumindest einer Seite mit einer aufgedampften Glasschicht (4) beschichtet ist.

25. Elektronisches Bauteil gemäß Anspruch 24, **dadurch gekennzeichnet, daß** auf der Glasschicht (4) eine das Bauteil verstärkende Kunststoffschicht (5) aufgebracht ist.

26. Elektronisches Bauteil gemäß einem der Ansprüche 24 oder 25, **dadurch gekennzeichnet, daß** das Substrat ausgedünnt ist.

27. Elektronisches Bauteil gemäß einem der Ansprüche 24 bis 26, **dadurch gekennzeichnet, daß** das Substrat auf einer zweiten Seite (1b), die einer ersten Seite (1a), mit Halbleiterstrukturen und Anschlußstrukturen gegenüberliegt, mit einer Passivierungsschicht (10, 11) versehen ist.

28. Elektronisches Bauteil gemäß einem der Ansprüche 24 bis 27, **dadurch gekennzeichnet, daß** die Glasschicht (4) eine Mischschicht aus anorganischen und organischen Bestandteilen umfaßt.

29. Elektronisches Bauteil gemäß einem der Ansprüche 24 bis 28, **gekennzeichnet durch** eine mehrschichtige **Glasschicht (4).**

30. Elektronisches Bauteil gemäß Anspruch 29, **dadurch gekennzeichnet, daß** die Schichten der Glasschicht unterschiedliche Zusammensetzungen aufweisen.

31. Elektronisches Bauteil gemäß einem der Ansprüche 24 bis 30, **dadurch gekennzeichnet, daß** das Substrat (1) auf einer zweiten Seite (1b) Leitungskontakte aufweist, welche mit Anschlußstrukturen auf der ersten Seite (1a) verbunden sind.

32. Elektronisches Bauteil gemäß Anspruch 31, **gekennzeichnet durch** ein Ball Grid Array (8) an den Leitungskontakten.

## Claims

1. Method of forming housings for electronic components, in particular sensors, integrated circuits and optoelectronic components; comprising the steps of:
- providing a substrate (1) which comprises one or several regions having semiconductor structures (2) and having terminal structures (3) or for forming semiconductor structures (2) and terminal structures (3), wherein at least a first substrate side (1a) is to be encapsulated,
- providing a vapour-deposition glass source (20),
- arranging the first substrate side (1a) relative to the vapour-deposition glass source such that the first substrate side (1a) can be vapour-deposited,
- vapour-depositing the first substrate side with a glass layer (4),
- thinning out the substrate (1) on the underside (1b),
- producing etching pits (6),
- producing line contacts (7) on the underside (1b).

2. Method as claimed in claim 1, **characterised in that** the one or several regions having semiconductor structures (2) are disposed on the first side (1a) of the substrate.

3. Method as claimed in claim 2, **characterised in that** the substrate is provided with a passivation layer (10, 11) on a second side (1b) lying opposite the first side (1a).

4. Method as claimed in any one of the preceding claims, wherein the substrate comprises a wafer, **characterised in that** the method includes packaging components in the wafer composite.

5. Method as claimed in any one of the preceding claims, **characterised in that** the substrate (1) is vapour-deposited on two sides (1a, 1b) with a glass layer (4, 10, 11).

6. Method as claimed in any one of the preceding claims, **characterised in that** a vapour-deposition glass source (20) is provided which produces at least one binary glass system.

7. Method as claimed in any one of the preceding claims, **characterised in that** the vapour-deposition glass source (20) is operated for as long as until the glass layer (4), in particular on the first substrate side, has a thickness in the range of 0.01 to 1000 µm.

8. Method as claimed in any one of the preceding claims, **characterised in that** upon provision of a vapour-deposition glass source (20) a reservoir is provided having organic constituents which change into the gaseous state by the application of a vacuum or by heating, so that during vapour-deposition mixed layers consisting of inorganic and organic constituents can be formed on the substrate side.

9. Method as claimed in any one of the preceding claims, **characterised in that** the glass layer thickness is in the range between 0.1 to 50 µm.

10. Method as claimed in any one of the preceding claims, **characterised in that** the glass layer thickness is in the range between 50 to 200 µm.

11. Method as claimed in any one of the preceding claims, **characterised in that** the vapour-deposition glass of the source (20) is produced by means of electron beam (24) from a glass target (23).

12. Method as claimed in any one of the preceding claims, **characterised in that** a borosilicate glass having portions of aluminium oxide and alkali oxides is used as the vapour-deposition glass.

13. Method as claimed in any one of the preceding claims, **characterised in that** the vapour-deposition glass has a coefficient of thermal expansion almost equal to that of the substrate.

14. Method as claimed in any one of the preceding claims, **characterised in that** the glass layer (4) is produced in a thickness, as required for hermetic closure, and a synthetic material layer (5) is applied over the glass layer (4) in order to facilitate the further processing of the substrate (1).

15. Method as claimed in any one of the preceding claims, **characterised in that** several layers of glass are vapour-deposited onto the substrate (1), wherein the glass layers can consist of different glass compositions.

16. Method as claimed in any one of the preceding claims, **characterised in that** the further processing of the substrate (1) includes the removal of material on a second substrate side (1b) which lies opposite the first substrate side (1a).

17. Method as claimed in any one of the preceding claims, **characterised in that** the substrate (1) comprises a wafer having several semiconductor structures (2) and terminal structures (3), wherein
the second substrate side (1b) lying opposite the first substrate side (1a) is thinned,
pits (6) are etched on the second substrate side (1b) in the region of the terminal structures to be produced,
the regions for forming the semiconductor structures (2) are lithographed using synthetic material layers,
line contacts (7) are produced on the second substrate side (1b) in the regions having terminal structures (3),
the synthetic material is removed from the second substrate side (1b),
a ball grid array (8) is applied to the line contacts (7), and
the wafer is separated for forming several electronic components which each comprise first encapsulated sides (1a).

18. Method as claimed in claim 17, **characterised in that** the second substrate side (1b) is provided with a synthetic material coating (10) while the ball grid regions (8) are left open.

19. Method as claimed in claim 17 or 18, **characterised in that**
after removing the synthetic material from the second substrate side (1b) the second substrate side is vapour-deposited entirely with a glass layer (11), and
the line contacts (7) are exposed by localised removal of the glass layer (11), after which the steps of applying the ball grid array (8) and of separation are performed, in order to obtain electronic components which are encapsulated on both sides.

20. Method as claimed in claim 19, **characterised in that** the second substrate side is vapour-deposited entirely with a glass layer (11) in the range of 1 to 50 µm thickness, and [*sic*]*.*

21. Method as claimed in any one of claims 17 to 20, **characterised in that** the etching pits (6) which lead up to the terminal structures (3) are filled with conductive material (12), after which, with or without removal of the synthetic material (10) on the second substrate side (1b) and with or without the glass layer (11) on the second substrate side (1b) while leaving the line contacts (7) free, the ball grid array (8) is applied to the line contacts (7) or to the filling material.

22. Method as claimed in any one of the preceding claims, **characterised in that** the vapour-deposition of the first substrate side (1a) with a glass layer (4) includes plasma ion-assisted deposition (PIAD).

23. Electronic component, in particular as a sensor or as an integrated circuit or as an optoelectronic component which can be produced by a method as claimed in any one of the preceding claims.

24. Electronic component as claimed in claim 23, which on a first side (1a) comprises one or several regions having semiconductor structures (2), and terminal structures (3), **characterised in that** the substrate is coated on at least one side with a vapour-deposited glass layer (4).

25. Electronic component as claimed in claim 24, **characterised in that** a synthetic material layer (5) which reinforces the component is applied on the glass layer (4).

26. Electronic component as claimed in any one of claims 24 or 25, **characterised in that** the substrate is thinned out.

27. Electronic component as claimed in any one of claims 24 to 26, **characterised in that** the substrate is provided with a passivation layer (10, 11) on a second side (1b) which lies opposite a first side (1a) having semiconductor structures and terminal structures.

28. Electronic component as claimed in any one of claims 24 to 27, **characterised in that** the glass layer (4) comprises a mixed layer consisting of inorganic and organic constituents.

29. Electronic component as claimed in any one of claims 24 to 28, **characterised by** a multilayered glass layer (4).

30. Electronic component as claimed in claim 29, **characterised in that** the layers of the glass layer comprise different compositions.

31. Electronic component as claimed in any one of claims 24 to 30, **characterised in that** on a second side (1b) the substrate (1) comprises line contacts which are connected to terminal structures on the first side (1a).

32. Electronic component as claimed in claim 31, **characterised by** a ball grid array (8) on the line contacts.

## Revendications

1. Procédé pour la formation de boîtiers dans le cas de composants électroniques, en particulier des capteurs, des circuits intégrés et des composants optoélectroniques, comprenant les étapes suivantes :
- mise à disposition d'un substrat (1) qui présente une ou plusieurs zones avec des structures à semi-conducteurs (2) et avec des structures de raccordement (3) ou pour la formation de structures à semi-conducteurs (2) et de structures de raccordement (3), au moins un premier côté du substrat (1a) étant destiné à être encapsulé,
- mise à disposition d'une source de verre appliqué par vaporisation (20),
- disposition du premier côté du substrat (1a) par rapport à la source de verre de métallisation sous vide de telle sorte que le premier côté de substrat (1a) peut être métallisé au vide ;
- vaporisation au vide du premier côté du substrat avec une couche de verre (4),
- amincissement du substrat (1) sur le côté inférieur (1b),
- génération de cavités de gravure (6),
- génération de contacts de circuit (7) sur le côté inférieur (1b).

2. Procédé selon la revendication 1, **caractérisé en ce que** la zone ou les multiples zones avec des structures à semi-conducteurs (2) sont disposées sur le premier côté (1a) du substrat.

3. Procédé selon la revendication 2, **caractérisé en ce que** le substrat est doté d'une couche de passivation (10, 11) sur un second côté (1b) opposé au premier côté (1a).

4. Procédé selon l'une des revendications précédentes, le substrat comprenant une tranche, **caractérisé en ce que** le procédé comprend le conditionnement de composants dans l'assemblage des tranches.

5. Procédé selon l'une des revendications précédentes, **caractérisé en ce que** le substrat (1) est métallisé au vide sur deux côtés (1a, 1b) avec une couche de verre (4, 10, 11).

6. Procédé selon l'une des revendications précédentes, **caractérisé en ce qu'**une source de verre appliqué par vaporisation (20) est mise à disposition, laquelle génère au moins un système de verre binaire.

7. Procédé selon l'une des revendications précédentes, **caractérisé en ce que** la source de verre appliqué par vaporisation (20) est exploitée jusqu'à ce que la couche de verre (4) présente en particulier sur le premier côté du substrat une épaisseur de l'ordre de 0,01 à 1000 µm.

8. Procédé selon l'une des revendications précédentes, **caractérisé en ce que**, lors de la mise à disposition d'une source de verre appliqué par vaporisation (20), on met à disposition un réservoir avec des composants organiques qui, par l'application d'un vide ou par réchauffement, passent à l'état gazeux, de sorte que, pendant la métallisation au vide, des couches mixtes à base de composants inorganiques et organiques peuvent être formées sur le côté du substrat.

9. Procédé selon l'une des revendications précédentes, **caractérisé en ce que** l'épaisseur de la couche de verre se situe entre 0,1 et 50 µm.

10. Procédé selon l'une des revendications précédentes, **caractérisé en ce que** l'épaisseur de la couche de verre se situe entre 50 et 200 µm.

11. Procédé selon l'une des revendications précédentes, **caractérisé en ce que** le verre appliqué par vaporisation de la source (20) est généré par faisceau électronique (24) à partir d'une cible en verre (23).

12. Procédé selon l'une des revendications précédentes, **caractérisé en ce qu'**un verre au borosilicate avec des fractions d'oxyde d'aluminium et d'oxydes alcalins est utilisé comme verre de métallisation sous vide.

13. Procédé selon l'une des revendications précédentes, **caractérisé en ce que** le verre de métallisation sous vide présente un coefficient de dilatation thermique pratiquement égal à celui du substrat.

14. Procédé selon l'une des revendications précédentes, **caractérisé en ce que** la couche de verre (4) est générée dans une épaisseur comme celle qui est indispensable pour la fermeture hermétique, et **en ce qu'**une couche de plastique (5) est appliquée au-dessus de la couche de verre (4), afin de faciliter le traitement ultérieur du substrat (1).

15. Procédé selon l'une des revendications précédentes, **caractérisé en ce que** plusieurs couches de verre sont appliquées par vaporisation sur le substrat (1), les couches de verre pouvant être constituées de différentes compositions de verre.

16. Procédé selon l'une des revendications précédentes, **caractérisé en ce que** le traitement ultérieur du substrat (1) comporte l'enlèvement de matériau sur un second côté du substrat (1b) qui fait face au premier côté du substrat (1a).

17. Procédé selon l'une des revendications précédentes, **caractérisé en ce que** le substrat (1) présente une tranche avec plusieurs structures à semi-conducteurs (2) et structures de raccordement (3),
le second côté du substrat (1b) faisant face au premier côté du substrat (1a) étant aminci,
des cavités (6) étant décapées sur le second côté du substrat (1b) dans la zone des structures de raccordement à fabriquer,
les zones destinées à former des structures à semi-conducteurs (2) étant lithographiées en utilisant des couches de plastique,
des contacts de circuit (7) étant établis sur le second côté du substrat (1b) dans les zones des structures de raccordement (3),
le plastique étant enlevé du second côté du substrat (1b),
un boîtier à billes ("Ball Grid Array") (8) étant appliqué sur les contacts de circuit (7), et
la tranche étant séparée pour former plusieurs composants électroniques, lesquels présentent à chaque fois des premiers côtés (1a) encapsulés.

18. Procédé selon la revendication 17, **caractérisé en ce que** le second côté du substrat (1b) est doté d'un revêtement plastique (10) avec l'évidement des zones "Ball Grid" (8).

19. Procédé selon la revendication 17 ou 18,
**caractérisé en ce que**,
après l'enlèvement du plastique du second côté du substrat (1b), le second côté du substrat est recouvert par vaporisation globalement avec une couche de verre (11), et
**en ce que** les contacts de circuit (7) sont mis à nu par l'élimination locale de la couche de verre (11), après quoi les étapes de l'application du boîtier à billes (8) et de la séparation interviennent, afin d'obtenir des composants électroniques encapsulés sur les deux côtés.

20. Procédé selon la revendication 19, **caractérisé en ce que** le second côté du substrat est recouvert par vaporisation globalement avec une couche de verre (11) d'une épaisseur allant de 1 à 50 µm.

21. Procédé selon l'une des revendications 17 à 20, **caractérisé en ce que** les cavités de gravure (6), qui vont jusqu'aux structures de raccordement (3), sont remplies avec du matériau (12) conductible, après quoi, avec ou sans l'enlèvement du plastique (10) sur le second côté du substrat (1b) et avec ou sans une couche de verre (11) sur le second côté du substrat (1b) et en laissant libres les contacts de circuit (7), le boîtier à billes (8) est appliqué sur les contacts de circuit (7) ou sur le matériau de charge.

22. Procédé selon l'une des revendications précédentes, **caractérisé en ce que** la vaporisation du premier côté du substrat (1a) avec une couche de verre (4) comprend l'application par vaporisation assistée avec des ions de plasma (PIAD).

23. Composant électronique, utilisé en particulier comme capteur ou comme circuit intégré ou comme composant optoélectronique, pouvant être fabriqué avec un procédé selon l'une des revendications précédentes.

24. Composant électronique selon la revendication 23, qui présente sur un premier côté (1a) une ou plusieurs zones avec des structures à semi-conducteurs (2) ainsi que des structures de raccordement (3), **caractérisé en ce que** le substrat est recouvert sur au moins un côté d'une couche de verre (4) appliquée par vaporisation.

25. Composant électronique selon la revendication 24, **caractérisé en ce qu'**une couche de plastique (5) renforçant le composant est appliquée sur la couche de verre (4).

26. Composant électronique selon l'une des revendications 24 ou 25, **caractérisé en ce que** le substrat est aminci.

27. Composant électronique selon l'une des revendications 24 à 26, **caractérisé en ce que** le substrat est doté d'une couche de passivation (10, 11) sur un second côté (1b) qui fait face à un premier côté (1a) avec des structures à semi-conducteurs et des structures de raccordement.

28. Composant électronique selon l'une des revendications 24 à 27, **caractérisé en ce que** la couche de verre (4) comporte une couche mixte à base de composants inorganiques et organiques.

29. Composant électronique selon l'une des revendications 24 à 28, **caractérisé par** une couche de verre (4) multicouche.

30. Composant électronique selon la revendication 29, **caractérisé en ce que** les couches de la couche de verre présentent différentes compositions.

31. Composant électronique selon l'une des revendications 24 à 30, **caractérisé en ce que** le substrat (1) présente sur un second côté (1b) des contacts de circuit qui sont reliés à des structures de raccordement sur le premier côté (1a).

32. Composant électronique selon la revendication 31, **caractérisé par** un boîtier à billes (8) sur les contacts de circuit.
